Europäisches Patentamt

(19) European Patent Office

Office européen des brevets

(11) Publication number: **0 016 511**
**B1**

(12) **EUROPEAN PATENT SPECIFICATION**

(45) Date of publication of patent specification: **02.03.83**

(51) Int. Cl.³: **H 03 K 17/965,**
**G 01 F 23/06, H 01 H 36/02**

(21) Application number: **80300071.0**

(22) Date of filing: **08.01.80**

(54) Float operated electrical switch assembly.

(30) Priority: **29.01.79 GB 7903012**

(43) Date of publication of application:
**01.10.80 Bulletin 80/20**

(45) Publication of the grant of the patent:
**02.03.83 Bulletin 83/9**

(84) Designated Contracting States:
**BE CH DE FR GB NL SE**

(56) References cited:
**DE - A - 2 107 584**
**DE - A - 2 241 199**
**GB - A - 940 219**
**GB - A - 1 490 266**
**US - A - 3 523 456**
**US - A - 3 535 664**

**ELEKTROTECHNIK, Vol. 55, No. 8, April 1973**
**P. VÖGELE "Lichtleitkabel, ein vielseitiges**
**Bauelement" pages 24 to 27**

(73) Proprietor: **BESTOBELL MOBREY LIMITED**
**190-196 Bath Road**
**Slough Berks. SL1 4DN (GB)**

(72) Inventor: **Denbow, Nicholas John**
**133 Ryefield Avenue**
**Uxbridge, Middlesex (GB)**

(74) Representative: **Jackson, Peter Arthur et al,**
**GILL JENNINGS & EVERY 53 to 64, Chancery**
**Lane**
**London WC2A 1HN (GB)**

## Float operated electrical switch assembly

The invention is concerned with a float-operated electrical switch assembly, for use with a boiler or other liquid container. The assembly has a float which follows the liquid level and is mounted with a primary magnet on the wet side of the assembly so that the primary magnet moves upon movement of the float. The primary magnet controls the movement of a secondary magnetic member by magnetic influence through a non-magnetic wall of a housing in which the secondary magnetic member is mounted. The secondary magnetic member is mounted on the dry side of the assembly and its movement controls an electrical output from the assembly. Such an assembly is hereinafter referred to as of the kind described.

In conventional assemblies of this kind, the secondary magnetic member, which may be a permanent magnet acting in attraction or repulsion with the primary magnet, or a member of ferromagnetic material, controls directly the operation of electrical switch contacts, for example by magnetic attraction of a contact carrier. The provision of the electrical contacts provides the major problem in such switch assemblies. Thus the magnetic interaction provides only limited contact pressure between the switch contacts, the switch contacts surfaces can be contaminated with dust or atmospheric pollution, and the presence of electrical contacts immediately adjacent to a liquid container necessitates the use of intrinsically safe circuits or explosion proof housings for the switch contacts in many applications where inflammable gases or liquids are present.

It is also known from DE—A—2,241,199 for the movement of the secondary magnetic member in a switch assembly of the kind described to control the electrical output from the assembly via a contactless transducer, e.g. inductively.

It is known to use for liquid level sensing purposes light transmitting fibre optics which pick up light at positions or to an extent depending upon the liquid level being sensed. However proposals (e.g. U.S. Patent Specification No. 3,523,456 which discloses a float operated optical shutter) for use of fibre optics in liquid level sensing systems have not been satisfactory as they have invariably involved transmission of light within the liquid container. This has involved difficulties of mounting the fibre optics, and possibly also a light source and/or a differentially reflecting surface within the container, particularly if the container is pressurized or contains a hazardous liquid. Other difficulties arise because of contamination of light transmitting, receiving, or reflecting surface of the optical system by deposit from the liquid in the container.

In accordance with the present invention, a switch assembly of the kind described, and in which the secondary magnetic member controls the electrical output from the assembly via a contactless transducer, is characterised in that the ends of at least one pair of light guides terminate in the housing with the end faces of the pair of light guides facing one another across a gap, one of the pair of light guides being associated externally of the housing with a light source and the other of the pair of light guides leading externally of the housing to a photosensitive device such that light originating from the light source can be transmitted from the end face of the one light guide across the gap onto the end face of the other light guide and transmitted therealong to the photo-sensitive device; and in that there is a part which moves, upon movement of the secondary magnetic member, to and fro in the gap between positions in which it is clear of or obstructs the light path across the gap between the end faces of the light guides.

This unique arrangement leads to a number of very important advantages. A primary factor compared with previous switch assemblies of the kind described is the elimination of electric switch contacts within the switch housing. As a result there are no cables carrying electricity immediately adjacent to the liquid container, but only safe light guides and there is no danger of sparking in the switch housing. The housing can therefore be of simpler construction, specifically it need no longer be an explosion proof box, and the conventional insert on which the secondary magnetic member is pivotally mounted need no longer be made of an electrically insulating material. Since the part which interrupts the light path moves freely between the end faces of the light guides, the magnetic interaction no longer needs to provide contact pressure. The magnetic interaction between the primary magnet and the secondary magnetic member only has to be sufficient to cause the secondary magnetic member to swing over from one end position to the other and the reduced force required, compared with previous switch assemblies, enables significant improvements in other respects. For example the gap between the primary magnet and secondary magnetic member could be increased, thereby enabling a thicker non-magnetic wall to be provided and consequently higher pressures to be contained safely. Alternatively the float and primary magnet could be smaller than previously, enabling the non-magnetic wall and surrounding flange, which is conventionally bolted to a hole in the container wall and supports the float and primary magnet, to be made smaller and therefore able to contain higher pressures and of reduced cost. Another advantage by comparison with the previous switch assemblies is that the contamination of electrical contacts at particularly high temperatures is no longer a problem.

Apart from the elimination of the conventional switch contacts, the use of the optical system has further advantages. Thus the whole of the optical system is isolated from the interior of the liquid container by the non-magnetic wall which separates the wet and dry sides of the switch assembly so that no part of the optical system has to pass through the wall of the container or to be mounted within the container. Contamination of the optical surfaces is therefore less likely but if any cleaning is required, this can be carried out on the dry side without needing access to the inside of the container. The optical system can be arranged to monitor dust build up or component ageing and render an alarm or failsafe as deterioration occurs. The power of the light source can be comparatively small, as, compared with previous optical liquid level sensing systems, it is no longer necessary to flood an area with light for selective reception by fibre optics mounted at different positions. Rather a narrow beam of light is directed across a gap between the end faces of the pair of light guides for selective interruption.

The light source and the photo-sensitive device may be located remote from the dry side housing by use for example of light guides extending over a distance in excess of 30 cms., and both the light source and the photo-sensitive device are preferably mounted in a common control box. As this box can be situated away from the liquid container, the box can be maintained at a more suitable temperature for electronic equipment than exists immediately adjacent to the liquid container, and it can be provided in an area isolated from flammable gases or liquids, and readily accessible for maintenance. The light guides are preferably fibre optics, such as fibre optic cables, although at least part of the guide adjacent the liquid container may need to be made of materials suitable for use at high temperatures, such as fibre optics made of glass, silica or quartz, or even single rods of such material. These could then be connected with low temperature fibre optic cable at suitable distances from the housing. The ends of the fibre optics or other light guides terminating in the housing may have plain ends, or the ends could be shaped to produce a more effective and narrow light beam in the housing. Additionally lenses could be used to improve the collimation of the beam.

The light source may be a lamp, a light emitting diode, a laser, or other source capable of producing a continuous or modulated beam of visible, infra red, or ultra violet light. The simplest form of modulation would be pulsing and the presence of such modulation would be useful to allow the electronics connected to the photo-sensitive device to check that the circuit is complete and that the light detected is the same as that transmitted. This gives an additional fail-safe feature should the light guide be broken.

The photo-sensitive device may be a photoelectric cell, a photo-diode, a light sensitive transistor, or other device which is arranged to produce or control an electrical output.

There may be two pairs of light guides with two corresponding light paths such that in each end position of the secondary magnetic member, one a light path is obstructed and the other unobstructed. This provides a fail-safe arrangement since a photo-sensitive device connected to one of the other light guides will always be energised.

In order to maximise the sensitivity, the end faces of the light guides of the or each pair are preferably closely spaced and the part which obstructs the light path is a thin vane shutter. By being closely spaced is meant that the opposed end faces of the two light guides of the pair are spaced by no more than 3 mm, the vane shutter then being thin enough to pass freely through this gap.

The secondary magnetic member may then be a bar magnet pivotally mounted about a transverse central axis, the shutter being pivotally mounted about the same axis as the secondary magnetic member and extending beyond the end of the secondary magnetic member, the shutter being caused to pivot with the secondary magnetic member by means of a part of the shutter which embraces an end of the secondary magnetic member.

There are two kinds of switch assembly to which the invention is clearly applicable. The first involves a float and primary magnet pivoted together about a horizontal axis on the wet side of a substantially vertical non-magnetic wall, the secondary magnetic member being a bar magnet pivotally mounted about a horizontal axis parallel to that about which the float and primary magnet are mounted, with like poles of the primary and secondary magnet being adjacent to one another across the non-magnetic wall so that the primary and secondary magnet act in repulsion. The second kind of switch assembly is of the so-called vertical type in which the primary magnet is a bar magnet with its poles vertically spaced mounted on a stem which extends upwards from the float and reciprocates in a non-magnetic tube extending upwards from the container. The secondary magnet is then also a bar magnet pivotally mounted to one side of the tube about a vertical axis. When one pole of the primary magnet is closer to the poles of the secondary magnet, it repells one and attracts the other pole of the secondary magnet, and vice versa.

One example of a switch assembly constructed in accordance with the present invention is illustrated in the accompanying drawings, in which:—

Figure 1 is a diagrammatic view showing the switch housing and related parts in vertical axial section;

Figure 2 is an elevation of internal parts of the switch housing as seen from the line II—II in Figure 1; and,

Figure 3 is an exploded perspective view showing the manner in which fibre optics are located in position.

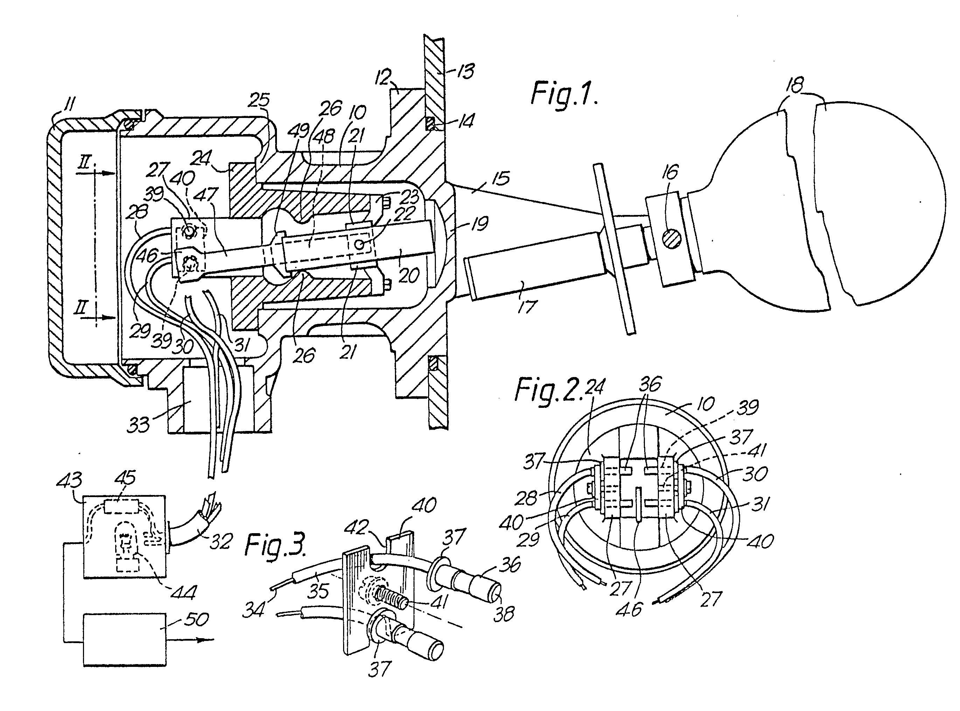

The illustrated switch assembly comprises a cast housing 10 made of stainless steel.or other non-magnetic material closed by a screw on end cap 11. The housing 10 is provided with an integral annular flange 12 through which studs or bolts (not shown) pass to secure the flange to a side wall 13 of a liquid container around an opening in the container wall. A sealing ring 14 is interposed between the flange 12 and wall 13. A pair of parallel ears 15, integral with the housing 10, extend through the opening in the container wall 13 and support between them on a pivot 16 a pivotable assembly including a primary bar magnet 17 and a float 18. The float 18 rises and falls with the liquid level in the container but the angle through which the pivotable assembly can swing is limited by abutments (not shown) on the ears 15 and assembly. Figure 1 shows the high liquid level position of the pivotable assembly.

The end of the primary magnet 17 remote from the float 18 moves closely adjacent to a thin diaphragm, or so called non-magnetic wall, portion of the housing 10 and cooperates by repulsion through the diaphragm 19 with a like pole at the adjacent end of a secondary magnet 20. The magnet 20 is held in a carrier 21 having laterally projecting stub axles 22 which are pivotally mounted in supports 23 bolted to the end of a metal insert 24 which in turn is secured by screws (not shown) to an internal shoulder of the housing 10. The secondary magnet 20 is thus able to swing about a horizontal axis parallel to the axis 16 and its angular movement is limited by engagement with humps 26 in the insert 24. Figure 1 shows the end position of the secondary magnet 20 corresponding to the illustrated end position of the primary magnet 17 and float 18. Naturally when the float 18 drops with the liquid level in the container, the two magnets will pass through a dead centre position as a result of which the secondary magnet will snap over in a clockwise direction as seen in Figure 1 to its other end position.

The insert 24 is provided with a pair of integral spaced parallel ear like wall portions 27, each of which acts as the support for the ends of two flexible fibre optic light guides 28, 29, 30 and 31 which form part of a composite light guide cable 32 which passes into the housing 10 through an opening 33. As shown in Figure 3, each light guide 28—31 has a light transmitting fibre optic core 34 within a sheath 35 and its end is secured within a brass ferrule 36 having a flange 37 so that the end face 38 of the light conducting core is exposed at the open end of the ferrule 36. Each of the wall portions 27 has two vertically spaced openings 39 extending through it and each of the four ferrules 36 extends through a respective one of the openings 39. The two ferrules passing through the holes in each one of the wall portions 27 are secured in position by means of an overlying H-shaped plate 40 which is tightened up against the outer face of the wall portion 27 by means of a screw 41. The plate 40 has a pair of U-shaped apertures 42 through which the respective fibre optic passes, but the width of the aperture is less than the diameter of the flange 37 so that the flanges 37 are trapped by the plate 40 against the outer face of the wall portion 27. This ensures that the end face 38 of the light transmitting core will lie at a predetermined position between the wall portions 27. As will be apparent from Figure 2, the arrangement is such that the end faces 38 of the fibre optics 28 and 30 face one another in axial alignment with a small gap between them. The end faces of the fibre optics 29 and 31 are similarly positioned in alignment facing one another at a lower position between the wall portions 27.

The other end of the cable 32, which may be a metre or more long, is coupled to a control unit 43 containing a source of light 44 and photo-sensitive devices 45. The light source 44 radiates light into the adjacent ends of the fibre optics 30 and 31 so that the light is transmitted along these fibre optics, and then from their end faces 38 across the respective gaps onto the opposed end faces of the fibre optics 28 and 29. Light received by these fibre optics is then transmitted therealong to the photo-sensitive devices 45 which provide digital electrical output signals depending upon whether a light signal of threshold intensity is received along the respective fibre optic 28 or 29 or not.

At any one time either the gap between the end faces 38 of the fibre optics 28 and 30 or the gap between the end faces 38 of the fibre optics 29 and 31 will be obstructed by a thin vane-like shutter 46. The shutter 46 forms the end part of a sheet metal arm 47, the other end of which is bifurcated and has legs 48 extending one down each side of the secondary magnet 20 and pivotally mounted with the secondary magnet 20 on the stub axles 22. The arm 47 and shutter 46 are caused to swing to and fro with the secondary magnet 20 by means of an integrally shaped part 49 which embraces the top and bottom of the adjacent end of the secondary magnet 20. Thus in the illustrated end position of the magnet 20, the shutter 46 obstructs the light path between the fibre optics 31 and 29 but a signal is transmitted through the fibre optics 30 and 28, and back to the respective photo-sensitive device 45. In the other end position of the secondary magnet 20 the light path between the fibre optics 30 and 28 is obstructed but a light signal is transmitted through the fibre optics 31 and 29 to the respective photo-sensitive device 45. The unit 43 therefore responds by producing an electrical signal depending upon whether the float 18 is in a raised or lowered position.

The signals from the unit 43 may be fed to a further control unit 50 which may be arranged to perform one or more functions such as automatic control of liquid replenishment of the container, operation of a high or low level alarm, a presentation of a visual or permanent recording of the fluctuations in the liquid level above and below the levels at which the float 18 and cooperating magnets 17 and 20 change over between their respective end positions.

## Claims

1. A float-operated electrical switch assembly of the kind having a float (18) which is mounted with a primary magnet (17) on the wet side of the assembly so that the primary magnet moves upon movement of the float, the primary magnet controlling the movement of a secondary magnetic member (20) by magnetic influence through a non-magnetic wall (19) of a housing (10) in which the secondary magnetic member is mounted, and the secondary magnetic member being mounted on the dry side of the assembly and its movement controlling via a contactless transducer an electrical output from the assembly, characterized in that the ends of at least one pair of light guides (28, 30; 29, 31) terminate in the housing (10) with the end faces of the pair of light guides facing one another across a gap, one of the pair of light guides being associated externally of the housing with a light source (44) and the other of the pair of light guides leading externally of the housing to a photo-sensitive device (45) such that light originating from the light source can be transmitted from the end face (38) of the one light guide (30, 31) across the gap onto the end face (38) of the other light guide (28; 29) and transmitted therealong to the photo-sensitive device; and in that there is a part (46) which moves, upon movement of the secondary magnetic member, to and fro in the gap between positions in which it is clear of or obstructs the light path across the gap between the end faces of the light guides.

2. An assembly according to claim 1, in which there are two pairs (28, 30; 29, 31) of light guides with two corresponding light paths such that in each end position of the secondary magnetic member, one light path is unobstructed and the other obstructed.

3. An assembly according to claim 1 or claim 2, in which the end faces of the light guides of the or each pair are closely spaced and the part which obstructs the light path is a thin vane shutter (46).

4. An assembly according to claim 3, in which the secondary magnetic member is a permanent magnet (21) pivotally mounted to an insert (24) in the housing (10), the insert having a pair of opposed walls (27) through each of which the end of one of the light guides of the or each pair projects so that the gap between the end faces of the two light guides of the or each pair is between the pair of opposed walls.

5. An assembly according to claim 4, in which the end of each light guide is secured in a ferrule (36) which extends through a respective one of the opposed walls (27) and is secured to the wall.

6. An assembly according to claim 5, in which the ferrule has a flange (37) which abuts the outer surface of the respective one of the opposed walls (27) and is overlayed by a fastener (40) which is secured to the outer surface of the wall to fix the ferrule and respective light guide end in position.

7. An assembly according to any one of claims 3 to 6, in which the secondary magnetic member is a bar magnet (21) pivotally mounted about a transverse central axis (22), the shutter (46, 47) is pivotally mounted about the same axis as the secondary magnetic member and extends beyond the end of the secondary magnetic member, the shutter being caused to pivot with the secondary magnetic member by means of a part (49) of the shutter which embraces an end of the secondary magnetic member.

## Patentansprüche

1. Eine Schwimmer betätigte elektrische Schalteranordnung der Art, die einen Schwimmer (18) aufweist, der mit einem Primärmagneten (17) auf der Naßseite der Anordnung angebracht ist, so daß sich der Primärmagnet bei Bewegung des Schwimmers bewegt, wobei der Primärmagnet mittels Magnetwirkung die Bewegung eines sekundären Magnetgliedes (20) durch eine nichtmagnetische Wandung (19) eines Gehäuses (10) hindurch, in dem das sekundäre Magnetglied angeordnet ist, schaltet und wobei das sekundäre Magnetglied auf der trockenen Seite der Anordnung angebracht ist und seine Bewegung über einen Kontaktfreien Wandler einen elektrischen Ausgang der Anordnung schaltet, dadurch gekennzeichnet, daß die Enden mindestens eines Paares Lichtleiter (28, 30; 29, 31) in dem Gehäuse (10) enden, wobei die Endflächen des Lichtleiterpaares beiderseits eines Spalts einander gegenüberliegen, einer der Lichtleiter des Paares außerhalb des Gehäuses mit einer Lichtquelle (44) verbunden ist und der andere Lichtleiter des Paares außerhalb des Gehäuses zu einer lichtempfindlichen Einrichtung (45) führt derart, daß von der Lichtquelle abgegebenes Licht von der Endfläche (38) des einen Lichtleiters (30, 31) über den Spalt auf die Endfläche (38) des anderen Lichtleiters (28; 29) übertragen und durch diesen zu der lichtempfindlichen Einrichtung übertragen werden kann, und daß ein Teil (46) vorgesehen ist, das sich bei Bewegung des sekundären Magnetgliedes in dem Spalt zwischen Positionen hin und her bewegt, in denen es sich außerhalb des Lichtweges durch den Spalt zwischen den Endflächen der Lichtleiter befindet oder diesen sperrt.

2. Eine Anordnung nach Anspruch 1, bei der zwei Paare (28, 30; 29, 31) Lichtleiter mit zwei entsprechenden Lichtwegen vorgesehen sind derart, daß in jeder Endposition des sekundären Magnetgliedes ein Lichtweg ungesperrt und der andere gesperrt ist.

3. Eine Anordnung nach Anspruch 1 oder Anspruch 2, bei der die Endflächen der Lichtleiter des oder jedes Paares eng beabstandet sind und das den Lichtweg sperrende Teil ein dünner Flügelverschluß (46) ist.

4. Eine Anordnung nach Anspruch 3, bei der das sekundäre Magnetglied ein schwenkbar an einem Einsatz (24) in dem Gehäuse (10) gelagerter Permanentmagnet (21) ist, wobei der Einsatz ein Paar einander gegenüberliegender Wände (27) aufweist und sich durch jede derselben einer der Lichtleiter des oder jeden Paares erstreckt, so daß sich der Spalt zwischen den Endflächen der zwei Lichtleiter des oder jedes Paares zwischen dem Paar gegenüberliegender Wände befindet.

5. Eine Anordnung nach Anspruch 4, bei der das Ende jedes Lichtleiters in einer Hülse (36) gehalten ist, die sich durch eine entsprechende der einander gegenüberliegenden Wände (27) erstreckt und an der Wand befestigt ist.

6. Eine Anordnung nach Anspruch 5, bei der die Hülse einen Bund (37) hat, der an der entsprechenden der einander gegenüberliegenden Wände (27) anliegt und von einem Befestigungsteil (40) überlagert ist, das an der Außenfläche der Wand befestigt ist, um die Hülse und das betreffende Lichtleiterende in ihrer Lage zu fixieren.

7. Eine Anordnung nach irgendeinem der Ansprüche 3 bis 6, bei der das sekundäre Magnetglied ein schwenkbar um eine quer liegende Mittelachse (22) gelagerter Stabmagnet (21) ist und der Verschluß (46, 47) schwenkbar um die gleiche Achse wie das sekundäre Magnetglied gelagert ist sowie sich über das Ende des sekundären Magnetgliedes hinaus erstreckt, wobei der Verschluß mit dem sekundären Magnetglied mittels eines Teils (49) des Verschlusses zum Schwenken gebracht wird, das ein Ende des sekundären Magnetgliedes umgreift.

**Revendications**

1. Ensemble commutateur électrique actionné par flotteur du type possédant un flotteur (18) qui est monté, en même temps qu'un aimant principal (17), du côté mouillé de l'ensemble de façon que l'aimant principal se déplace lorsque le flotteur se déplace, l'aimant principal commandant le déplacement d'un élément magnétique secondaire (20) par influence magnétique au travers d'une paroi non magnétique (19) d'un boîtier (10) dans lequel l'élément magnétique secondaire est monté, l'élément magnétique secondaire étant monté du côté sec de l'ensemble et son déplacement commandant, par l'intermédiaire d'un transducteur sans contact, une sortie électrique de l'ensemble, caractérisé en ce que les extrémités d'au moins une paire de guides de lumière (28, 30; 29, 31) aboutissent dans le boîtier (10) de façon que les faces terminales de la paire de guides de lumière regardent l'une vers l'autre au travers d'un intervalle, un premier guide de la paire de guides de lumière étant associè, à l'extérieur du boîtier, à une source de lumière (44) et l'autre guide de la paire de guides de lumière conduisant, à l'extérieur du boîtier, à un dispositif photo-sensible (45) de façon que la lumière venant de la source de lumière puisse être transmise de la face terminale (38) du premier guide de lumière (30, 31) à la face terminale (38) de l'autre guide de lumière (28; 29) au travers de l'intervalle, puis transmisele long de l'autre guide de lumière jusqu'au dispositif photo-sensible; et en ce qu'il existe une pièce (46) qui effectue, avec le déplacement de l'élément magnétique secondaire, un mouvement de va-et-vient dans l'intervalle entre des positions dans lesquelles il dégage ou obstrue le trajet de la lumière au travers de l'intervalle entre les faces terminales des guides de lumière.

2. Ensemble selon la revendication 1, dans lequel il existe deux paires (28, 30; 29, 31) de guides de lumière auxquelles correspondent deux trajets de lumière de façon que, dans chaque position terminale de l'élément magnétique secondaire, un trajet de lumière soit libre et l'autre soit obstrué.

3. Ensemble selon la revendication 1 ou 2, dans lequel les faces terminales des guides de lumière de la paire ou de chaque paire sont étroitement rapprochées et la pièce qui obstrue le trajet de lumière est un obturateur à lame mince (46).

4. Ensemble selon la revendication 3, dans lequel l'élément magnétique secondaire est un aimant permanent (21) monté pivotant sur une pièce rapportée (24) dans le boîtier (10), la pièce rapportée possédant une paire de parois opposées (27) au travers de chacune desquelles l'extrémité de l'un des guides de lumière de la paire ou de chaque paire fait saillie de façon que l'intervalle entre les faces terminales des deux guides de lumière de la paire ou de chaque paire soit entre les parois de la paire de parois opposées.

5. Ensemble selon la revendication 4, dans lequel l'extrémité de chaque guide de lumière est fixée dans une bague (36) qui traverse l'une respective des parois opposées (27) et est fixée à la paroi.

6. Ensemble selon la revendication 5, dans lequel la bague possède un rebord (37) qui est en appui contre la surface extérieure de l'une respective des parois opposées (27) et est recouvert par un élément de fixation (40) qui est fixé à la surface extérieure de la paroi afin de maintenir la bague et l'extrémité du guide de lumière respectif en position.

7. Ensemble selon l'une quelconque des revendications 3 à 6, dans lequel l'élément magnétique secondaire est un aimant droit (21) monté pivotant sur un axe central transversal (22), l'obturateur (46, 47) est monté pivotant sur le même axe que l'élément magnétique secondaire et s'étend au-delà de l'extrémité de l'élément magnétique secondaire, l'obturateur étant amené à pivoter avec l'élément magnétique secondaire par l'intermédiaire d'une pièce (49) de l'obturateur que embrasse une extrémité de l'élément magnétique secondaire.

Fig.1.

Fig.2.

Fig.3.

0016511